# EUROPEAN PATENT SPECIFICATION

(11) **EP 4 354 151 B1**
(45) Date of publication and mention of the grant of the patent: **25.11.2026**
(21) Application number: 22306536.8
(22) Date of filing: 11.10.2022
(51) Int. Cl.: G01P 15/125, G01P 15/08

(54) **ACCELEROMETER HAVING A GROUNDED SHIELD STRUCTURE**
BESCHLEUNIGUNGSMESSER MIT GEERDETER ABSCHIRMSTRUKTUR
ACCÉLÉROMÈTRE AYANT UNE STRUCTURE DE BLINDAGE MISE À LA TERRE

(43) Date of publication of application: 17.04.2024
(73) Proprietor: STMicroelectronics International N.V., 1228 Plan-les-Ouates, Geneva (CH)
(72) Inventor: ENJALBERT, Jerome Romain, 31023 Cedex 1 Toulouse (FR)
(74) Representative: Studio Torta S.p.A.

(56) References cited:
- US-A1- 2012 105 080
- US-A1- 2016 103 174
- US-A1- 2022 170 958

## Description

### TECHNICAL FIELD

Embodiments of the subject matter described herein relate generally to dual mass accelerometer devices and analog front ends for such devices.

### BACKGROUND

Accelerometer devices find application in a wide variety of applications and systems. In particular, dual mass accelerometers find wide use. Accordingly, there is a need for dual mass accelerometers with high sensitivity.

US 2022/170958 Al discloses a sensor package that includes a first die having a capacitor sensor that includes an active sensing portion and a shield surrounding the active sensing portion. The sensor package further includes a second die that includes a voltage regulator configured to produce a shield voltage and a compensation circuit configured to produce a compensation signal. The voltage regulator and the compensation circuit are electrically coupled to the shield. The voltage regulator is configured to regulate the shield to the shield voltage and the compensation signal produced by the compensation circuit is configured to reduce an interference signal on the shield voltage. The compensation circuit includes one or more coupling capacitors that may be programmable capacitor arrays and calibration methodology entails selecting capacitance values for the programmable capacitor arrays that minimizes the error on an output signal of the sensor package.

US 2012/105080 A1 discloses a high-accuracy electrostatic capacitance type physical quantity sensor and angular velocity sensor configured so as to be capable of suppressing noise derived from internal noise while maintaining resistance to externally-incoming noise. A detection element has a movable mass supported displaceably by a physical quantity given from the outside, and a detection electrode. A shield wire is disposed around wirings connected to the input of a capacitance detection circuit and is connected to a dc potential of low impedance.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.

It is emphasized that in the following, the so-called embodiments relating to figures 2A to 2C are not embodiments of the invention, but are examples which are not covered by the claims.
FIGs 1A, 1B, and 1C (referred to collectively herein as FIG. 1) show top and side, cross-sectional views along cutlines 1B-1B and 1C-1C of a capacitive transducer in accordance with an embodiment;
FIGs 2A, 2B, and 2C (referred to collectively herein as FIG. 2) show a block diagram, a schematic diagram of an accelerometer device, and a graphical representation of voltage versus time of the accelerometer;
FIGs 3A, 3B, and 3C (referred to collectively herein as FIG. 3) show a block diagram, a schematic diagram of an accelerometer device, and a graphical representation of voltage versus time of the accelerometer, according to an embodiment;
FIGs 4A, 4B, 4C, and 4D (referred to collectively herein as FIG. 4) show top and side cross sectional views along cutlines 4B-4B, 4C-4C, and 4D-4D of an accelerometer apparatus in accordance with an embodiment; and
FIG. 5 shows a flow diagram in accordance with an embodiment of a method.

### SUMMARY

According to the invention there is provided an accelerometer device and a method as defined by the appended claims.

### DETAILED DESCRIPTION

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary, or an example is not necessarily to be construed as preferred or advantageous over other implementations. Furthermore, there is no intention to be bound by any expressed or implied theory presented in the preceding technical field, background, or the following detailed description.

To achieve high sensitivity, dual-mass accelerometers based on microelectromechanical systems (MEMS) need strong immunity against external interference and high signal to noise ratio. These accelerometers also require low power consumption.

Dual mass accelerometer front ends typically include a capacitive transducer with MEMS elements and sensitive sensing circuitry (e.g., application-specific integrated circuits ("ASIC's") that detect capacitance changes of movable electrodes affixed to movable masses or proof masses and fixed electrodes in response to the motion of the accelerometer. Capacitance changes are typically detected by applying an excitation signal to the fixed electrode and then detecting the capacitance of the movable electrode using the stimulus provided by the excitation signal. Given the sensitivity of the movable masses to electrostatic forces, the fixed electrodes and electrodes associated with the proof masses are usually kept to the same potential (e.g., a reference voltage, V_{REF that} may have a value of approximately 0.8V). Shield structures may be formed around the movable masses and the fixed electrodes to prevent external interference. To achieve immunity against these external interferers such as communication signals querying the ASIC and other noise sources, a shield structure may surround the movable masses. The shield structure and voltage regulator(s) that may be electrically coupled to it may absorb the external interference without disturbing the potential of the mobile masses, thus avoiding undesired changes in capacitance. In addition, the voltage regulator may maintain a potential of the shield structures constant and equal to the potential of the proof masses to cancel the undesired effect of electrostatic forces. Because of power consumption constraints, the voltage regulator power capability is typically limited and cannot maintain a fixed shield voltage in the case of a large interference signal. In some cases, this means that querying the system with a communication signal or other potential interferers must be restricted to time periods where acceleration is not being sensed to avoid unwanted noise.

The current invention described herewith allows the shield of the dual mass accelerometer front end to be biased at a ground potential to make the accelerometer more tolerant to external interferers and to eliminate the need for using a voltage regulator to maintain the potential of the shield. As used herein, the term "ground potential", "fixed ground potential," or "ground" refers to a voltage level that is approximately zero volts. In addition, circuitry simultaneously maintains a ground potential on the movable electrodes. In this way, maximum resistance against interference may be simultaneously achieved with low electrostatic force between shield and movable masses, according to an embodiment. In addition, maintaining a ground potential for movable electrodes allow differential measurements of the device capacitance to be achieved using larger amplitude voltages without significantly increasing the power furnished to the accelerometer.

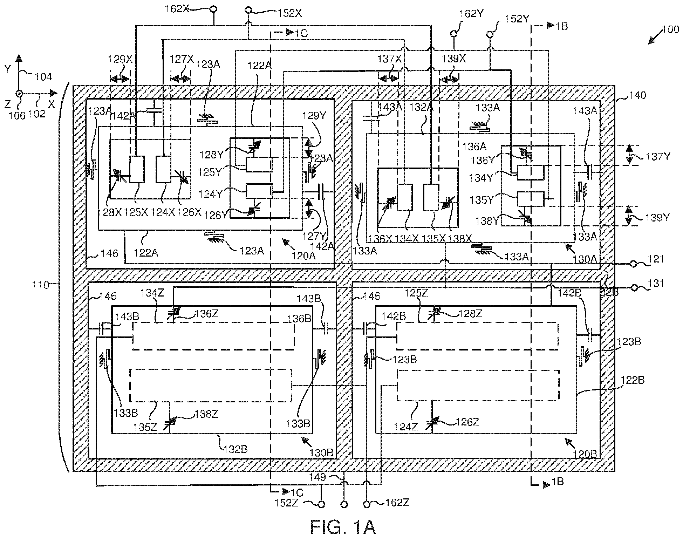

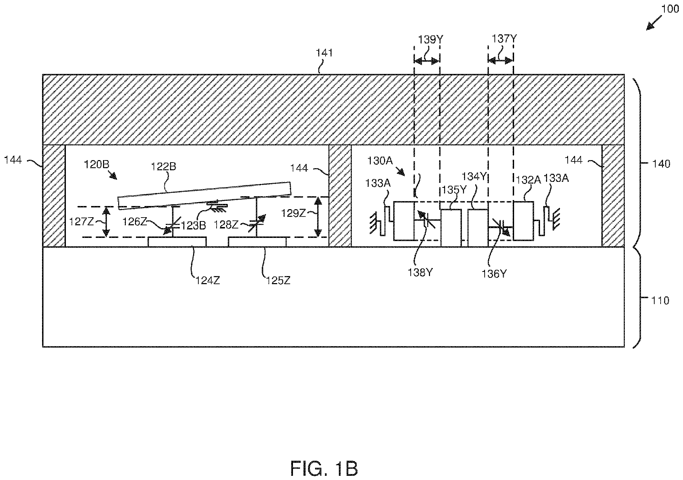

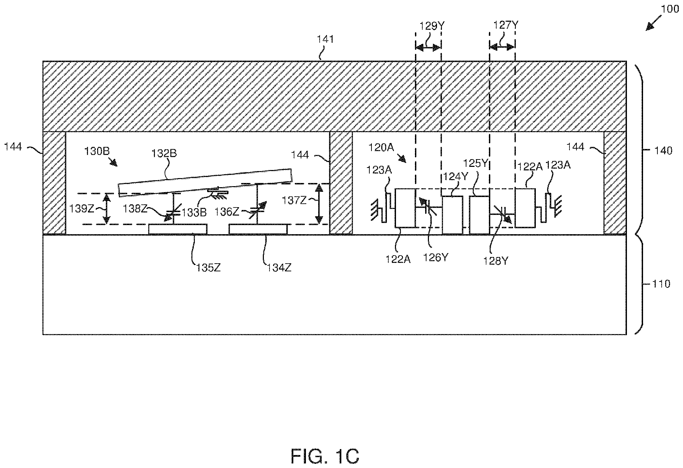

FIGs 1A, 1B, and 1C (referred to collectively herein as FIG. 1) show top and side, cross-sectional views along cutlines 1B-1B and 1C-1C of a capacitive transducer, in accordance with an embodiment. Referring simultaneously to FIGs 1A, 1B, 1C, and in an embodiment, the capacitive transducer 100 includes a substrate 110, first in-plane proof mass 120A, first out-of-plane proof mass 120B (both referred to collectively as "first proof mass 120"), and second in-plane proof mass 130A, second out-of-plane proof mass 130B (both referred to collectively as "second proof mass 130"). The first proof mass 120 and second proof mass 130 are coupled to the substrate 110. In an embodiment, each of the first and second proof masses 120, 130 may include first and second in-plane proof masses 120A, 130A that respond to acceleration in an X direction 102 and a Y direction 104 and first and second out-of-plane proof masses 120B, 130B that respond to acceleration in a Z-direction 106.

The first proof mass 120 includes first in-plane and out-of-plane movable electrodes 122A, 122B that are electrically coupled to first X, Y, Z fixed electrodes 124X, 124Y,124Z (referred to collectively as first fixed electrodes 124) and to second X, Y, Z fixed electrodes 125X, 125Y, 125Z (referred to collectively as second fixed electrodes 125), according to an embodiment. Likewise, in an embodiment, the second proof mass 130 includes second in-plane and out-of-plane movable electrodes 132A, 132B electrically coupled to third X, Y, Z fixed electrodes 134X, 134Y, and 134Z (referred to collectively as third fixed electrodes 134) and to fourth X, Y, Z fixed electrodes 135X, 135Y, and 135Z (referred to collectively as fourth fixed electrodes 135). In an embodiment, the first and second in-plane proof masses 120A, 130A may be coupled to the substrate 110 via spring connections 123A, 133A. The first and second out-of-plane proof masses 120B, 130B may be coupled to the substrate 110 via, e.g., torsion spring connections 123B, 133B in a "teeter totter" configuration. In an embodiment, spring connections 123A, 133A and torsion spring connections123B, 133B may be formed from the same material used to form the first and second proof masses 120, 130. When the substrate 110 moves, and depending on the direction of the movement, the inertia of the first and second proof masses 120, 130 may cause the first and second X distances 127X, 129X, first and second Y distances 127Y, 129Y, first and second Z distances 127Z, 129Z, third and fourth X distances 137X, 139X, third and fourth Y distances 137Y, 139Y, and third and fourth Z distances 137Z, 139Z between the first and second movable electrodes 122A, 122B, 132A, 132B and the first and second fixed X electrodes 124X, 125X, first and second fixed Y electrodes 124Y, 125Y, first and second fixed Z electrodes 124Z, 125Z and third and fourth fixed X electrodes 134X, 135X, third and fourth fixed Y electrodes, 134Y, 135Y, and third and fourth fixed Z electrodes 134Z, and 135Z to change. This results in changes in first X, Y, Z capacitances 126X, 126Y, and 126Z (referred to collectively as first capacitance 126), second X, Y, Z capacitances 128X, 128Y, 128Z (second capacitance 128), third X, Y, Z capacitances 136X, 136Y, 136Z (third capacitance 136), and fourth X, Y, Z capacitances 138X, 138Y, 138Z (fourth capacitance 138), according to an embodiment. For example, when the substrate 110 is moved in the +X direction 102, the first and fourth X distances 127X and 139X may decrease and the second and third X distances 129X and 137X may increase, while the associated first and fourth X capacitances 126X and 138X may increase and the second and third X capacitances 128X and 136X decrease, according to an embodiment. In an embodiment, when the substrate 110 is moved in the +Y direction 104, the second and third Y distances 129Y and 137Y may decrease and the first and fourth Y distances 127Y and 139Y may increase, while the associated first and fourth Y capacitances 126Y and 138Y may decrease and the second and third Y capacitances 128Y and 136Y may increase. Looking at Fig.1B and Fig.1C, When the substrate 110 is moved in the +Z direction 106, the second and third Z distances 129Z and 137Z may increase and the first and fourth Z distances 127Z and 139Z may decrease, while the associated first and fourth Z capacitances 126Z and 138Z may increase and the second and third Z capacitances 128Z and 136Z may decrease, according to an embodiment.

In an embodiment, the capacitive transducer 100 may employ a dual mass that includes each of the in-plane proof masses 120A, 130A and each of the out-of-plane proof masses 120B, 130B of the first and second proof masses 120, 130. First and second movable electrode terminals 121, 131 may be coupled to the first and second proof masses 120, 130 and may be electrically coupled to first and second movable electrodes 122A, 122B, 132A, 132B, according to an embodiment. For example, the in-plane and out-of-plane proof masses 120A, 120B included in the first proof mass 120 may include electrically coupled first in plane and out of plane movable electrodes 122A, 122B, according to an embodiment. In contrast, the first fixed X, Y, and Z electrodes 124X, 124Y, and 124Z corresponding to each of the in-plane and out of plane masses 120A, 120B may be coupled to the sensor circuitry, described below, and may be coupled to independent electrical connections that allows a particular fixed electrode to be selected, according to an embodiment. For example, and in an embodiment, in-plane acceleration in the +X-direction 102 may be detected by injecting a test voltage into the first and second fixed electrodes terminals 152X, 162X that are electrically coupled to first, second, third, and fourth X fixed electrodes, 124X, 125X and 134X, 135X while being uncoupled from first, second, third, and fourth Y fixed electrodes, 124Y, 125Y, 134Y, and 135Y as well as first, second, third, and fourth Z fixed electrodes, 124Z, 125Z, 134Z, and 135Z. According to an embodiment, measurements of acceleration in the X, Y, or Z direction may be ascertained by selecting the fixed electrodes to be excited and then determining the differential change in capacitance between the first and second in-plane and out-of-plane movable electrodes, e.g., 122A and 132A, or 122B and 132B and the corresponding first and second fixed electrodes, e.g., first and second X electrodes 124X, 125X.

In an embodiment, the shield structure 140 is coupled (e.g., bonded) to the substrate 110. The shield structure 140 may include an upper shield portion 141 and a lower shield portion 144. The upper and lower shield portions 141, 144 may be formed from one or more substantially electrically conductive materials, e.g., metals (e.g., aluminum, copper, gold), conductive Si, poly Si, or other suitable conductive materials. In an embodiment, a glass frit or other suitable material may be used to bond the shield structure to the substrate 110. The shield structure 140 may include one or more shield electrodes 146. In an embodiment, the shield electrode 146 is electrically coupled to a fixed ground potential. In other embodiments (not shown), the shield structure 140 may be electrically coupled to circuitry or external connections that maintains the potential of the shield to approximately zero volts. In other examples (not shown), the shield electrode may be electrically coupled to a reference voltage, e.g., V_{REF}. Capacitive coupling between the shield structure 140 and the first and second in-plane and out of plane proof masses 120A, 120B, 130A, 130B, may result in shield-to-movable-electrode capacitances 142A, 142B, 143A, 143B (referred to collectively as shield-to-movable-electrode capacitances 142, 143).

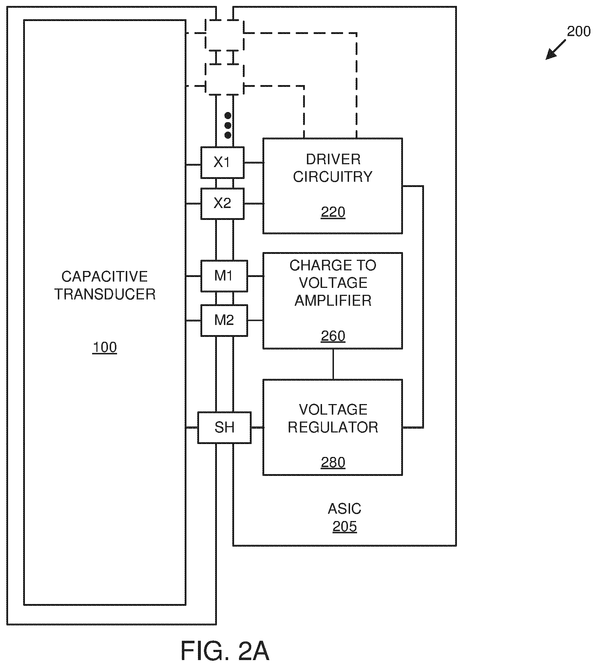

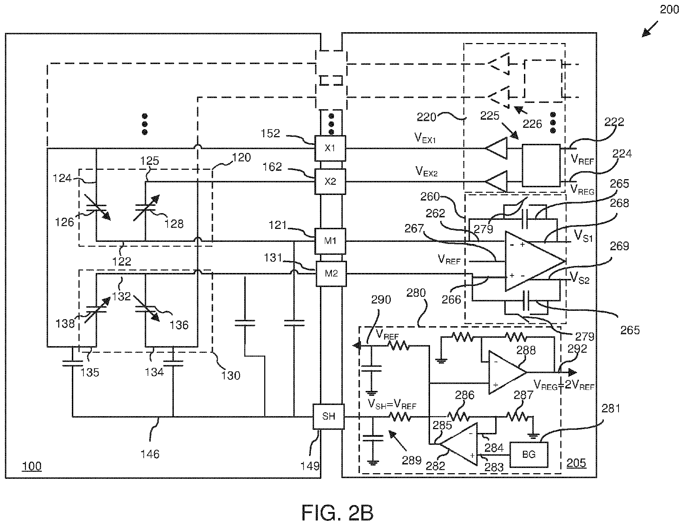

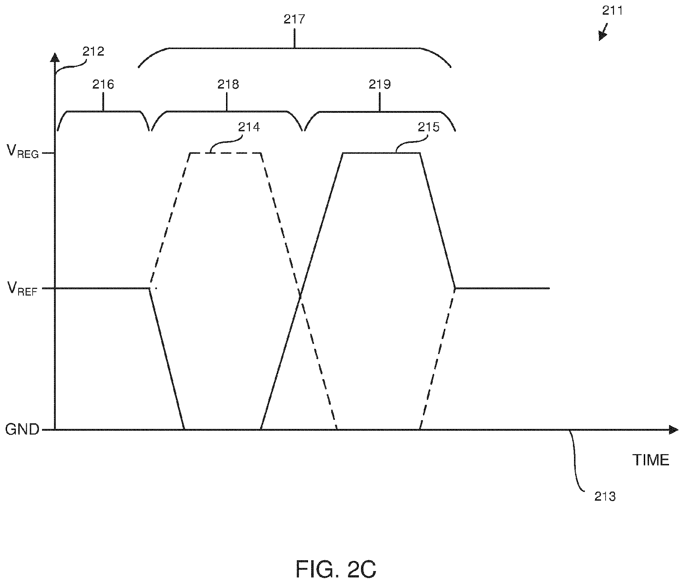

FIGs 2A, 2B, and 2C (referred to collectively herein as FIG. 2) show a block diagram, schematic diagram of an accelerometer device, and a graphical representation of voltage versus time of the accelerometer. An understanding of the operation of the accelerometer 200 may be accomplished by simultaneously viewing FIGs 2A, 2B, and 2C. In this example, a capacitive transducer 100 may be coupled to an application specific integrated circuit (ASIC) 205. The ASIC may include driver circuitry 220 coupled to the fixed electrode terminals 152, 162 of the capacitive transducer 100. A charge to voltage amplifier (C2V) 260 may be electrically coupled to the first and second movable electrode terminals 121, 131 of the capacitive transducer. A voltage regulator 280 may be electrically coupled to the driver circuitry 220 (connection not shown), the C2V 260, and the shield terminal 149 of the capacitive transducer 100.

The driver circuitry 220 includes a driver 225 electrically coupled to the first and second fixed electrode terminals 152, 162, and a switch network (not shown) that controls which of the fixed electrodes of the capacitor transducer are excited with excitation voltages, V_{EX1}, applied to the first fixed electrode terminal 152 and V_{EX2}, applied to the second fixed electrode terminal 162. In the example of FIG. 2, the connections to the first fixed electrode terminals 152 correspond to the X fixed electrodes 124X and 134X and the second fixed electrode terminal 162 corresponds to X fixed electrodes 125X, 135X. The driver circuitry 220 receives two supply input voltages V_{REF} and V_{REG at} inputs 222, 224. Additional driver(s) 226, shown symbolically in dotted lines, but, in like manner and partially omitted for clarity and simplicity, may correspond to Y fixed electrodes and Z fixed electrodes 124Y, 125Y, 134Y, 135Y, 124Z, 125Z, 134Z, 135Z, according to an embodiment.

The C2V amplifier 260 is configured as a differential operational amplifier that senses the capacitance between first and second in-plane and out-of-plane movable electrodes 122A, 122B, 132A, 132B and first X, Z, Z fixed electrodes 124X, 124Y, 124Z (i.e., "first fixed electrode"), second X, Y, Z fixed electrodes 125X, 125Y, and 125Z (i.e., "second fixed electrode"), third fixed X, Y, Z electrodes 134X, 134Y, and 134Z (i.e., "third fixed electrode"), and fourth fixed X, Y, Z electrodes 135X, 135Y, and 135Z (i.e. "fourth fixed electrode"). The C2V amplifier 260 includes first and second differential inputs 262, 266, a differential reference input 267 and first and second outputs 268, 269. The C2V amplifier is configured to produce output voltages V_{S1,} Vs₂ at each of the first and second outputs 268, 269 to minimize the difference between first and second differential inputs 262, 266 with respect to the voltage at the differential reference input 267. With excitation voltage signals V_{EX1} and V_{EX2} applied to the fixed electrode terminals 152, 162, the C2V amplifier 260 may be used to read the capacitance C_{S1} and C_{S2} seen at the first and second movable electrode terminals 121, 131. During steady state operation of the C2V (e.g., reset phase 216 when capacitance is not being measured), a steady state value of V_{REF} is applied to the fixed electrode terminals. During first and second portions 218, 219 of amplification phase 217, when the excitation voltage signals V_{EX1} and V_{EX2} are applied to the fixed electrode terminals 152, 162, switches 279 are open, resulting in a potential seen at the first and second movable electrode terminals 121 and 131 being reflected across feedback capacitors 265, C_{FB} and the first and second outputs 268, 269. The single ended output of each of the branches of the C2V as a function of excitation voltage signals V_{EX1} and V_{EX2} may be calculated as V_{S1} = 0.5*(V_{EX1} - V_{EX2}) * (C_{M1XYZ1} - C_{M1XYZ2}) / C_{FB} and V_{S2} = 0.5*(V_{EX1} - V_{EX2}) * (C_{M2XYZ1} - C_{M2XYZ2}) / C_{FB} where C_{MM1XYZ1} corresponds to one of first X, Y, Z capacitances 126X, 126Y, 126Z (referred to collectively as first capacitance 126), C_{M1XYZ2} corresponds to one of second X, Y, Z capacitances 128X, 128Y, 128Z (referred to collectively as second capacitance 128), C_{MZXYZ1} corresponds to one of third X, Y, Z capacitances 136X, 136Y, 136Z (referred to collectively as third capacitance 136), and C_{M2XYZ2} corresponds to one of the fourth X, Y, Z capacitances 138X, 138Y, 138Z (referred to collectively as fourth capacitance 138), according to an embodiment. Ideally, and in an embodiment, as a function of the excitation voltages, V_{EX1} and V_{EX2}, the C2v output, V_{S1} - V_{S2}, may be calculated as 0.5*(V_{EX1} - V_{EX2}) * 4*dC / C_{FB} where dC refers to differential capacitance which is multiplied by a factor of four since there are four capacitances (i.e., first, second, third, fourth capacitances 126, 128, 136, 138) in each direction, X, Y, and Z. This sensed differential voltage represents the capacitance change seen at the first and second movable electrode terminals 121, 131 and corresponds to an acceleration in the direction selected, depending on which of X, Y, Z first fixed electrodes 124X, 124Y, 124Z, X, Y, Z second fixed electrodes 125X, 125Z, 125Z, and X, Y, Z third fixed electrodes 134X, 134Y, 134Z, and X, Y, Z fourth fixed electrodes 135X, 135Z, 135Z, are excited with the excitation voltages V_{EX1}, V_{EX2}.

The C2V amplifier 260 and the driver circuitry 220 receive a voltage input, e.g., V_{REF} and V_{REG} from voltage regulator 280. Voltage regulator 280 includes a voltage reference 281, and first and second operational amplifiers ("op-amp") 282, 288. As used herein, the term "op-amp" refers to an amplifier with a voltage gain of more than 1 that includes an inverting input and a non-inverting input. As an example, the first op-amp 282 is arranged in a series voltage regulator configuration with a voltage reference 281 (e.g., bandgap voltage reference) connected at its non-inverting input 283, a first resistor 286, denoted R₁, connected between the inverting terminal 284 and output 285 with a second resistor 287, denoted R₂, connected between the inverting terminal 284 and ground. The voltage, V_{REF}, at the output 285 is given by V_{R}(R₁+R₂)/R₂. In this example, the values of the voltage reference 281 and first and second resistor values are configured to yield a voltage for V_{REF} of approximately 0.8 V in some embodiments, although higher or lower values of V_{REF} may be used in other embodiments. The second op-amp 288 is configured in a similar way (e.g., with equal values of resistors R₁ and R₂, other details omitted for brevity) to achieve a value, V_{REG} at the output of the second op-amp of approximately twice the value of its input, e.g., 2V_{REF} or approximately 1.6 V (in the case that V_{REF} is 0.8 V. As used herein, "approximately twice the value" means that the difference between the magnitude of two times the value of interest (e.g., 2*V_{REF}) and the magnitude of the value of the quantity being compared (e.g., V_{REG}) is greater than twenty percent of the magnitude of the quantity being compared (e.g., V_{REG}), according to an embodiment. The first and second outputs 290, 292 of voltage regulator 280 are at V_{REF} and V_{REG} and are electrically coupled to the C2V 260, driver circuitry 220, and shield terminal 149 (through RC network 289 for isolation) to supply the needed voltage levels at V_{REF} and V_{REG}.

Referring simultaneously to FIG. 2B and 2C, the measurement of capacitances by applying voltages at the first and second fixed electrode terminals 152, 162 may be further understood. In graph 211 of FIG. 2C, ordinate 212 depicting voltage versus abscissa 213 depicting time is shown. Trace 214 represents the voltage seen at the first fixed electrode terminal 152 (corresponding to first and third fixed electrodes 124, 134) and trace 215 represents the voltage seen at the second fixed electrode terminal 162 (corresponding to second and fourth fixed electrodes 125, 135). The driver circuitry 220 maintains a steady state voltage of V_{REF} at the fixed electrode terminals 152, 162 during reset phase 216. During a first portion 218 of amplification phase 217, the voltage applied to the fixed electrode terminals 152, 162 may cycle from V_{REF} to V_{REG} at the first fixed electrode terminal 152, as shown in trace 214, and from V_{REF} to ground or 0V at the second fixed electrode terminal 162 as shown in trace 215. During a second portion 219 of amplification phase 217, the voltage applied to the first and second fixed electrode terminals 152, 162 may cycle from V_{REF} to V_{REG} at the second fixed electrode terminal 162, as shown in trace 215, and from V_{REF} to ground or 0V at the first fixed electrode terminal 152 as shown in trace 214. Thus, during each of the first and second portions 218, 219 of amplification phase 217 the difference in potential between the first fixed electrode terminal 152 and the second fixed electrode 162 is V_{REG} (e.g., 1.6 V).

In some situations, interferers from external noise, communications may be applied to the shield structure 140. In some of these cases, the voltage regulator may not be able to supply the current necessary to maintain the shield voltage at V_{REF}. Also, the amplitude of the excitation signals for V_{EX1} and V_{EX2} place limitations on the amplitude of the measured sense signals, V_{S1,2} and the resultant signal-to-noise ratio. Thus, accelerometers with more ability to maintain a constant shield voltage and to use excitation signals with higher amplitude may be desired.

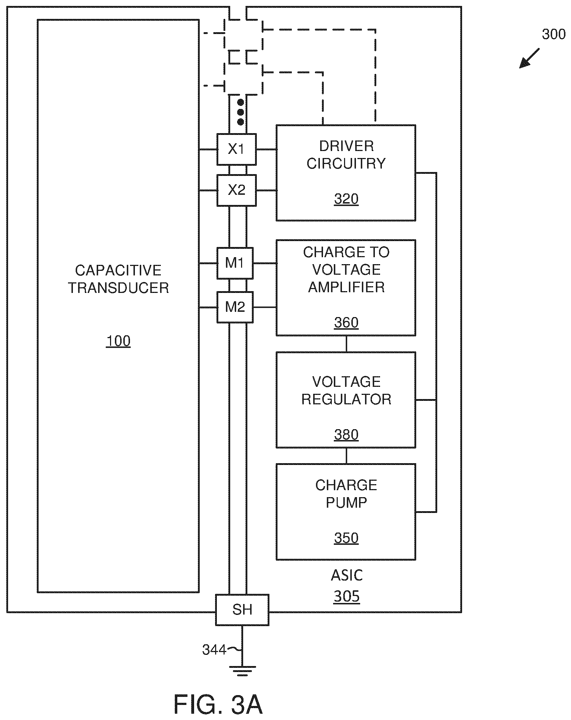

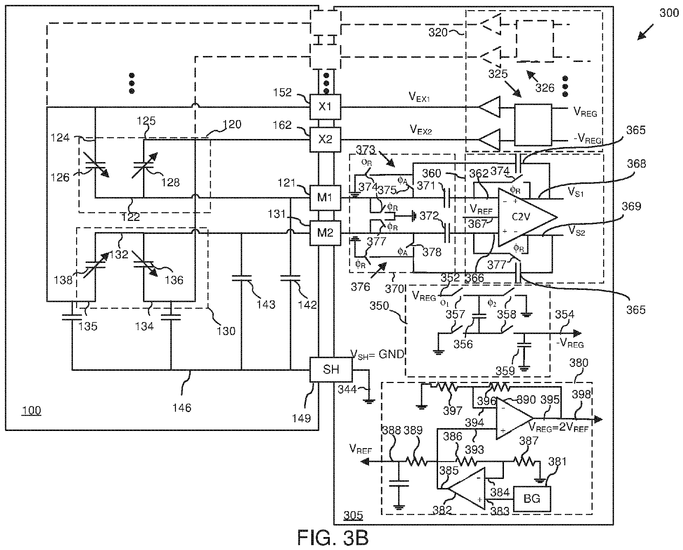

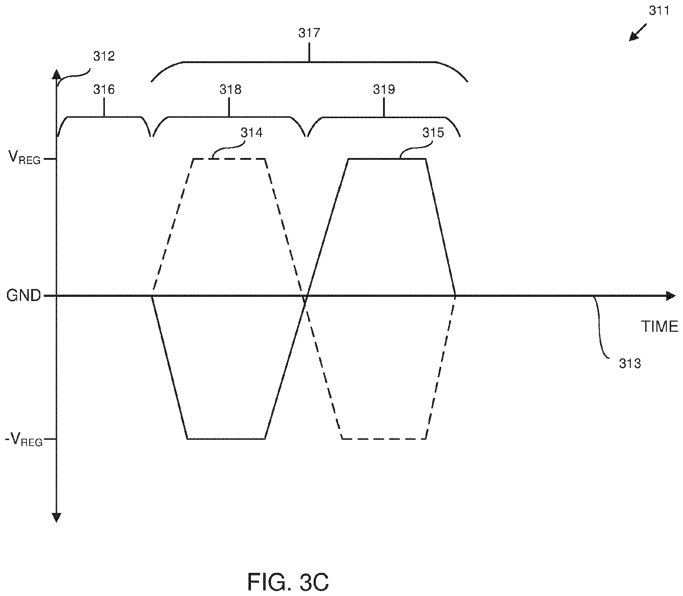

FIGs 3A, 3B, and 3C (referred to collectively herein as FIG. 3) show a block diagram, schematic diagram of an accelerometer device 300 according to the invention, and a graphical representation of voltage versus time of the accelerometer,. Accelerometer 300 includes the capacitive transducer 100 coupled to an integrated circuit 305 (e.g., ASIC) and a shield structure 140 coupled to a ground potential.

Referring simultaneously to FIGs 3A and 3B, the capacitive transducer 100 includes the substrate 110, first and second proof masses 120 (i.e., 120A, 120B), 130 (130A, 130B) coupled to the substrate 110, and the shield structure 140 coupled to the substrate 110, according to an embodiment. The capacitive transducer 100 is coupled to integrated circuit 305.

The first proof mass 120 is coupled to the substrate 110 and electrically coupled to a first in-plane and out-of-plane movable electrodes 122A, 122B that are electrically coupled to one or more of first X, Y, and Z fixed electrodes 124X, 124Y, 124Z ("first fixed electrode") and second X, Y, and Z fixed electrodes 125X, 125Y, 125Z ("second fixed electrode"). Because these fixed electrodes are selectively enabled, they are referred to collectively as first and second fixed electrodes 124, 125. A second proof mass 130 is coupled to the substrate 110 and electrically coupled to second movable electrodes 132A, 132B and electrically coupled to one or more third X, Y, and Z fixed electrodes 134X, 134Y, and 134Z (i.e., "third fixed electrode"), and fourth X, Y, and Z fixed electrodes 135X, 135Y, and 135Y (i.e., "fourth fixed electrode"), referred to as third and fourth fixed electrodes 134, 135.A shield structure 140 is coupled to the substrate 110, the first proof mass 120, and the second proof mass 130, wherein the shield structure 140, is electrically coupled to a fixed ground potential 344.

The integrated circuit 305 includes driver circuitry 320, a charge pump 350 (i.e., "charge pump circuit"), a charge to voltage amplifier (C2V) 360, and a voltage regulator 380 (i.e., "voltage source"). Like-numbered components (e.g., driver circuitry 320) are analogous to numbered items of FIG. 2 (e.g., driver circuitry 220).

Analogous to the driver circuitry 220 of FIG. 2, the driver 325 drives the first and second fixed electrode terminals 152, 162. In the example of FIG. 3, driver circuitry shows connections to fixed electrode terminals 152, 162 with connections to first, second, third, and fourth X fixed electrodes 124X, 125X, 134X, and 135X. Also analogous to FIG. 2, additional driver circuitry 326, shown symbolically in dotted lines, but partially omitted for clarity simplicity may correspond to Y fixed electrodes and Z fixed electrodes 124Y, 125Y, 134Y, 135Y, and 124Z, 125Z, 134Z, 135Z, according to an embodiment.

The charge pump 350 is electrically coupled to the first and second fixed electrodes 124, 125 and to third and fourth fixed electrodes 134, 135 through driver circuitry 320. The charge pump 350 is coupled to the driver circuitry 320 and is configured to generate a negative supply rail 354 (i.e., "inverted voltage"). The C2V amplifier 360 may be electrically coupled to the first proof mass 120 and the second proof mass 130 through first and second movable electrode terminals 121, 131.

In an embodiment, the charge pump 350 may include a positive supply rail 352 (i.e., "input voltage"), a negative supply rail 354 (i.e., "inverted voltage"), a flyback capacitor 356, input switches 357, and output switches 358. During operation, the input switches 357 are closed and the flyback capacitor 356 is charged to a value of V_{REG} during a first portion or phase of a clock cycle, ϕ₁. During a second portion or phase of a clock cycle, ϕ₂, the input switches 357 may be open and the output switches 358 are closed, according to an embodiment. In an embodiment, closing the output switches 358 may place the electrode of the flyback capacitor 356 to V_{REG} at a ground reference potential, thus a value of -V_{REG} is reflected at the negative supply rail 354 across a load capacitor 359. In an embodiment, the flyback capacitor 356 may have a capacitance between about 1 picofarad and about 10 picofarads. In other embodiments, the flyback capacitor 356 may have a capacitance of between about 1 picofarad and about 100 picofarads although other larger or smaller values may be used. In an embodiment, the load capacitor 359 may have a capacitance between about 2 picofarads and about 10 picofarads. In other embodiments, the load capacitor 359 may have a capacitance of between about 1 picofarad and about 100 picofarads although other larger or smaller values may be used.

The C2V amplifier 360 includes a first input 362, a second input 366, a reference input 367, a first output 368, and a second output 369. The C2V amplifier 360 is coupled to a level-shifting circuit 370 to enable the first and second movable electrode terminals 121, 131 to remain at zero volts while allowing the voltage at the first and second inputs 362, 366 to be at a non-zero value, e.g., V_{REF}. According to an embodiment, the level-shifting circuit may be implemented using a switched capacitor circuit. The level-shifting circuit 370 may include first and second input capacitors 371, 372 that couple first and second switch capacitor circuits 373 and 376 to the first and second inputs 362 and 366 of the C2V 360. In an embodiment, the first and second input capacitors 371, 372 may have values in a range of about 0.2 picofarad to about 1 picofarad. In other embodiments, the first and second input capacitors 371, 372 may have values in a range of about 0.1 picofarad to about 10 picofarads, though other higher or lower values of first and second input capacitors 371, 372 may be used. In an embodiment, the level-shifting circuit 370 may shift the first potential at the first input 362 of the C2V amplifier 360 and at the second input 366 of the C2V amplifier 360 to zero volts at the first and second movable mass electrodes 122, 132. In an embodiment, the level shifting may be accomplished using a correlated double sampling (CDS) technique. Using the CDS technique, the level shifting may be accomplished by closing first switches 374, 377 while maintaining second switches 375, 378 in an open position during a reset period, denoted ϕ_{R}, (i.e., "first state"). During the reset time period, the first and second fixed electrode terminals 152, 162, electrically coupled to the first and second movable electrodes 122, 132, may be held at a ground potential because first switches 374 and 377 are in a closed position, according to an embodiment. During an amplification phase (i.e., "second state"), denoted ϕ_{A}, the first switches 374, 377 may be opened and second switches 375, 378 may be closed. In this configuration, level shifting is accomplished because first and second inputs 362, 366 are held to a V_{REF} potential by the virtual short between first and second inputs 362, 366 and the reference input 367, according to an embodiment. In an embodiment, the voltage applied to first and second input capacitors 371, 372 is V_{REF} at the first and second inputs 362 and 366 ("first input potential" and "second input potential") and 0V at the connection to second and fourth switches 375, 378. During the amplification phase, first and third switches 374, 377 may be open while the second and fourth switches, 375, 378 may be closed, to allow transferring charge from the first, second, third, fourth capacitances 126, 128, 136, 138 into first and second feedback capacitors 365 and first and second outputs 368, 369.

An embodiment may include a voltage regulator 380 electrically coupled to driver circuitry 320. The voltage regulator may include a bandgap reference circuit 381 that may be electrically coupled to a first op amp 382 that is, in turn, coupled to V_{REF} output 388 through resistor 389. First op amp 382 may include first and second inputs 383, 384, and first output 385 and may be electrically coupled to first and second feedback resistors 386, 387. A V_{REF} output 388 may be coupled to second op-amp 390 at a third input 393. Fourth input 394 may be coupled to third and fourth feedback resistors 396, 397. A second output 395 of the second op-amp 390 may be coupled to V_{REG} output 398. Other design details and operation of voltage regulator 380 may be analogous to the voltage regulator 280 of FIG. 2, according to an embodiment. For the sake of brevity, the construction and operation of the voltage regulator 380 are not repeated here. It should be appreciated that the implementation of voltage regulator 380 is exemplary and in other embodiments, other voltage regulator architectures may be used without limitation.

Referring simultaneously to FIG. 3B and 3C, the measurement of capacitances by applying voltages at the first and second fixed electrode terminals 152, 162 may be further understood. In graph 311 of FIG. 3C, ordinate 312 depicting voltage versus abscissa 313 depicting time is shown. Trace 314 represents the voltage seen at the first fixed electrode terminal 152 (i.e., "first excitation voltage") corresponding to first and second fixed electrodes 124, 125. Trace 315 represents the voltage seen at the second fixed electrode terminal 162 (i.e., "second excitation voltage") corresponding to third and fourth X, Y, Z fixed electrodes 134, 135. The driver circuitry maintains a steady state voltage of 0V at the fixed electrode terminals 152, 162 during reset phase 316 (i.e., "first state"). In an embodiment, the steady time period may be between about 100 microseconds and about 300 microseconds. In other embodiments, the steady time period may be between about 10 microseconds and 10000 microseconds, though other shorter or longer time periods may be used. During a first portion 318 of amplification phase 317 (i.e., "second state"), the voltage applied to the fixed electrode terminals 152, 162 may cycle from a ground or 0V potential to V_{REG} at the first fixed electrode terminal 152, as shown in trace 314, and from ground or 0V to -V_{REG} at the second fixed electrode terminal 162, as shown in trace 315. In an embodiment, the amplification phase 317 may be between about 10 microseconds and about 30 microseconds. In other embodiments, the amplification phase 317 may be between about 1 microsecond and 1000 microseconds, though other shorter or longer time periods may be used. During a second portion 319 of the amplification phase 317, the voltage applied to the fixed electrode terminals 152, 162 may cycle from ground or 0V to V_{REG} at the second fixed electrode terminal 162, as shown in trace 315, and from ground or 0V to -V_{REG} at the first fixed electrode terminal 152 as shown in trace 315. Thus, during each of the first and second portions 318, 319 of the amplification phase 317, the total voltage amplitude applied at the first and second fixed electrodes 124, 125 and third and fourth fixed electrodes 134, 135 to be sensed by the capacitance at their respective first and second movable masses 122A, 122B, 132A, 132B may be approximately two times V_{REG} (e.g., 3.2 V), according to an embodiment. In other embodiments where higher or lower values of V_{REF} than 0.8 V are used, higher or lower values of V_{REG} and the total voltage amplitude may be achieved.

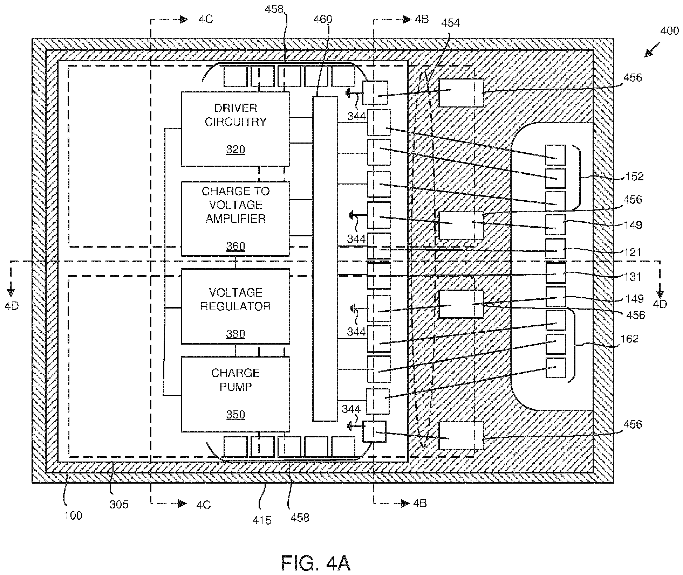

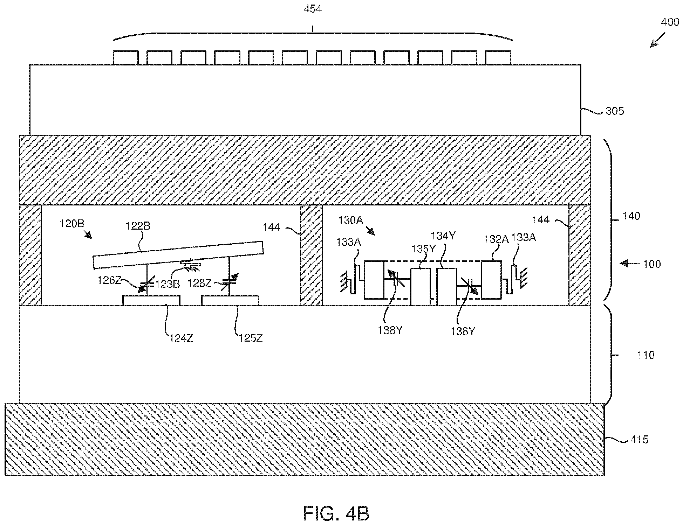

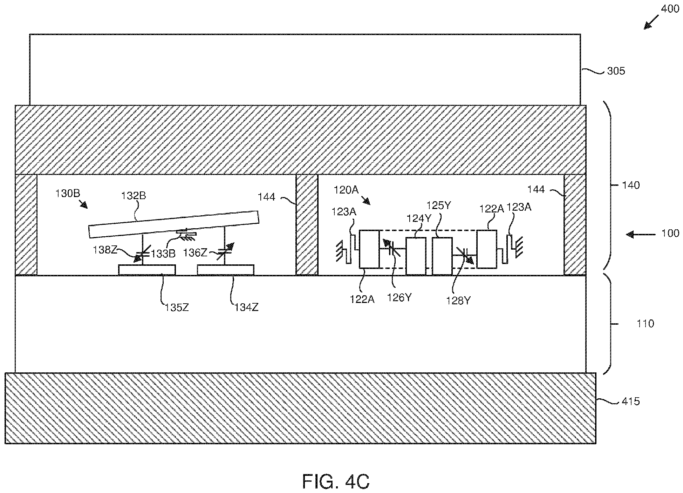

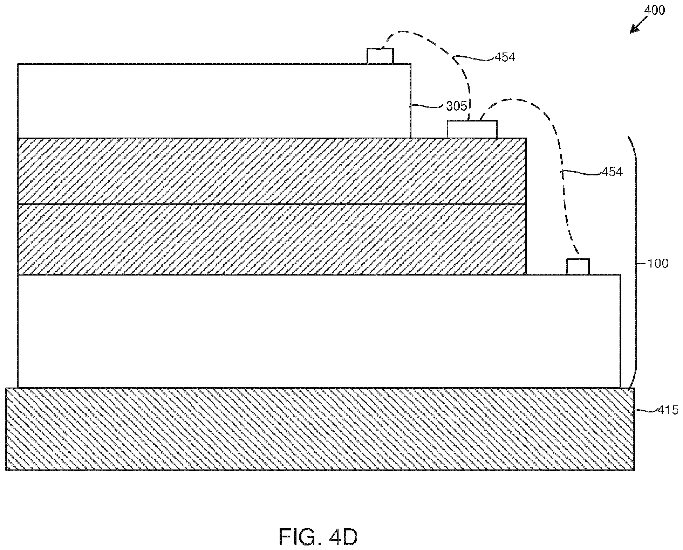

FIGs 4A, 4B, 4C, and 4D are top and cross-sectional side views along cutlines 4B-4B, 4C-4C, and 4D-4D of a dual mass accelerometer apparatus 400 in accordance with an embodiment. In an embodiment, a dual mass accelerometer apparatus may include the capacitive transducer 100 of FIG. 1, the integrated circuit 305 of FIG. 3, and a package 415. As the capacitive transducer 100 and integrated circuit 305 correspond respectively to the capacitive transducer 100 of FIG. 1 and integrated circuit 305 of FIG. 3, described previously. For the sake of brevity, the detailed operation of the capacitive transducer 100 and the integrated circuit 305 will not be repeated in conjunction with the description of this figure.

In an embodiment, the capacitive transducer 100 includes first proof masses 120A, 120B coupled to the substrate 110 and includes first movable electrodes 122A, 122B, 132A, 132B, and is electrically coupled to first and second X fixed electrodes 124X (not shown) and 125X (not shown), first and second Y fixed electrodes 124Y and 125Y, first and second Z fixed electrodes 124Z and 125Z, third and fourth X fixed electrodes 134X (not shown) and 135X (not shown), third and fourth Y fixed electrodes 134Y and 135Y, and third and fourth Z fixed electrodes 134Z and 135Z. The shield structure 140 may be coupled to the substrate 110, the first proof masses 120A, 120B and the second proof masses 130A, 130B, wherein the shield structure 140 is electrically coupled to a ground potential. The dual mass accelerometer apparatus 400 may further include an integrated circuit 305 coupled to the first proof masses 120A, 120B, second proof masses 130A, 130B, and the shield structure 140, according to an embodiment. In an embodiment, the integrated circuit 305 may be electrically coupled via connection circuitry 460 to the first and second X, Y, Z fixed electrodes 124X (not shown), 125X (not shown), 124Y, 125Y, 124Z, and 125Z (not shown) through the first fixed electrode terminal 152, and to the third and fourth X, Y, Z fixed electrodes 134X (not shown), 135X (not shown), 134Y, 135Y, 134Z, and 135Z through the second fixed electrode terminal 162, according to an embodiment. The voltage source 380 having a reference voltage value is coupled to the driver circuitry 320, wherein the voltage source 380 is configured to amplify the reference voltage value to a maximum voltage value. The charge pump 350 is electrically coupled to the driver circuitry 320 and the voltage source 380, wherein the charge pump 350 is configured to generate a voltage approximately equal to in magnitude and opposite in polarity that of the maximum voltage value. A charge-to-voltage amplifier 360 having a first input and a second input, wherein the first input is at a first potential and electrically coupled to the first movable electrodes 122A, 122B of the first proof masses 120A, 120B, and wherein the second input is at a second potential and electrically coupled to the second movable electrodes 132A, 132B of the second proof masses 130A, 130B.

In an embodiment, the dual mass accelerometer apparatus 400 may include a package flange 415, wherein the capacitive transducer 100 and the integrated circuit 305 may be coupled to the flange portion. In an embodiment, the package flange 415 may be electrically coupled to a ground potential and the shield portion 140 of the capacitive transducer may be coupled the package flange 415, thus providing a ground connection to the shield portion 140 of the capacitive transducer 100. Die bonding using solder or adhesive (e.g., epoxy or other suitable adhesive(s)) may be used to attach the capacitive transducer 100 and the integrated circuit 305 to the package 415, according to an embodiment. In an embodiment, the integrated circuit 305 may be bonded to the capacitive transducer. In other embodiments, the integrated circuit 305 may be bonded to the package flange 415 (not shown). Bond wires 454 or other suitable electrical connections may be used to electrically couple the integrated circuit 305 to the capacitive transducer 100. External bond pads 458 may be used to route supply power and input/output connections to the accelerometer apparatus 400. Shield bond pads 456 may be used to electrically couple (e.g., electrically connect) the shield structure 140 to ground potential 344 provided by the integrated circuit 305.

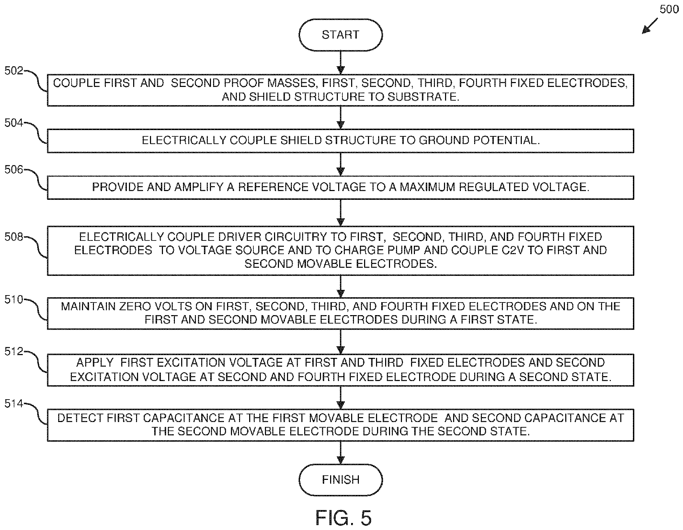

FIG. 5 is a flow diagram 500 in accordance with an embodiment of a method. Referring simultaneously to FIG. 5 and FIG. 3, in block 502 embodiment of the method includes providing a substrate 110, a first proof mass 120 (120A, 120B) coupled to the substrate 110 that includes first movable electrodes 122A, 122B and is electrically coupled to X, Y, Z first and second fixed electrodes 124X, 125X, 124Y, 125Y, 124Z, and 125Z (first and second fixed electrodes 124, 125) and a second proof mass 130 (130A, 130B) coupled to the substrate 110 that includes second movable electrodes 132A, 132B that is electrically coupled to the X, Y, Z, third and fourth fixed electrodes 134X, 135X, 134Y, 135Y, 134Z, and 135Z (third and fourth fixed electrodes 134, 135).

In block 504 the method further includes coupling the shield structure 140 to the substrate 110, the first proof mass 120, the second proof mass 130, and electrically coupling the shield structure 140 to the ground potential 344, according to an embodiment.

In block 506 the method may also include providing a voltage, e.g., V_{REF} (i.e., "reference voltage") at the voltage regulator 380 (i.e., "reference voltage source"). The method also includes amplifying the reference voltage, e.g., using the voltage regulator 380, to higher voltage, e.g., V_{REG}, (i.e., "maximum regulated voltage"), according to an embodiment.

Referring now to block 508, and in an embodiment, the method includes electrically coupling driver circuitry 320 to the first and second fixed electrodes terminals 152, 162 corresponding to first and third fixed electrodes 124, 134 and to the second and fourth fixed electrodes 125, 135 and electrically coupling the charge pump 350 to the driver circuitry 320. The method includes electrically coupling the charge-to-voltage amplifier 360 having a first input and a second input to the first movable electrodes 122A, 122B and to the second movable electrodes 132A, 132B. The method includes producing, by the charge pump 350, a voltage having a value opposite to in polarity of the first excitation voltage during a second state, wherein a difference in a magnitude of the first excitation voltage and a magnitude of the second excitation voltage is less than twenty percent of the magnitude of the first excitation voltage. In other embodiments, the difference in the magnitude of the first excitation voltage and a magnitude of the second excitation voltage may be less than ten percent of the magnitude of the first excitation voltage.

Referring now to block 510, the method includes maintaining, by the driver circuitry 320, a ground potential (or approximately 0V) at the first fixed electrodes 124, 125 and the second fixed electrodes 134, 135 during the steady state period (i.e., first state).

Referring now to block 512, an embodiment of the method includes applying, by the driver circuitry, a first voltage pulse (i.e., first excitation voltage) at the first fixed electrode terminal 152 corresponding to the first and third fixed electrodes 124, 134 having a value of V_{REG} (i.e., the maximum regulated voltage). A second voltage pulse (i.e., second excitation voltage) isapplied at the second fixed electrode terminal 162 corresponding to the second and fourth fixed electrodes 125, 135 having a value opposite to in polarity of V_{REG} (e.g. -V_{REG}) (i.e., first excitation voltage) during a second state. A difference in a magnitude of the first excitation voltage and a magnitude of the second excitation voltage is less than twenty percent of the magnitude of the first excitation voltage. In other embodiments, a difference in a magnitude of the first excitation voltage and a magnitude of the second excitation voltage may be less than ten percent of the magnitude of the first excitation voltage during the first voltage pulse during the measurement period (i.e., second state).

Referring now to block 514, the method includes detecting, by the charge-to-voltage amplifier 360, a first capacitance, (one of pairs of X, Y, Z capacitances 126X, 128X, 126Y, 128Y, 126Z, 128Z, collectively capacitances 126, 128) at the first movable electrodes 122A, 122B at the first input 362 of the charge-to-voltage amplifier 360 and a second capacitance (one of pairs of X, Y, Z capacitances 136X, 138X, 136Y, 138Y,136Z, 138Z, collectively capacitances 136, 138) at the second movable electrodes 132A, 132B at the second input 366 of the charge-to-voltage amplifier 360. It should be appreciated that the capacitances measured may be one of first, second, third, and fourth X, Y, Z capacitances 126X, 128X, 126Y, 128Y, 126Z, and 128Z and one of 136X, 138X, 136Y, 138Y, 136Z, and 138Z, depending on which of the fixed electrodes are active during the capacitance measurements, according to an embodiment.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

For the sake of brevity, conventional semiconductor fabrication techniques may not be described in detail herein. In addition, certain terminology may also be used herein for reference only, and thus are not intended to be limiting, and the terms "first", "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

## Claims

1. An accelerometer device (300) comprising:
- a shield structure (140) coupled to a substrate (110), to a first proof mass (120), and to a second proof mass (130), wherein the first proof mass (120) includes a first movable electrode (122A, 122B) that is electrically coupled to a first fixed electrode (124) and a second fixed electrode (125), and wherein the second proof mass (130) includes a second movable electrode (132A, 132B) that is electrically coupled to a third fixed electrode (134) and to a fourth fixed electrode (135), wherein the shield structure (140) is further electrically coupled to a fixed ground potential (344);
- a voltage source electrically coupled to a driver circuitry (320), the voltage source having a reference voltage at an input to the voltage source, wherein the voltage source is configured to amplify the reference voltage to a maximum regulated voltage;
- the driver circuitry (320) being further electrically coupled to the first fixed electrode (124), second fixed electrode (125), third fixed electrode (134), and fourth fixed electrode (135), wherein the driver circuitry (320) is configured to maintain a ground potential at the first fixed electrode (124), the second fixed electrode, the third fixed electrode (134), and the fourth fixed electrode (135) in a first state and is configured to apply a first excitation voltage at the first fixed electrode (124) and the third fixed electrode (134) at the maximum regulated voltage and a second excitation voltage at the second fixed electrode (125) and fourth fixed electrode (135) having a value opposite to in polarity of the first excitation voltage during a second state;
- a charge pump (350) electrically coupled to the driver circuitry (320), wherein the charge pump (350) is configured to produce a voltage opposite to in polarity to the maximum regulated voltage, wherein a difference in a magnitude of the voltage and the magnitude of the maximum regulated voltage is less than twenty percent of the magnitude of the voltage; and
- a charge-to-voltage amplifier (360), having a first input and a second input, electrically coupled to the first movable electrode (122A, 122B) and to the second movable electrode (132A, 132B), wherein the charge-to-voltage amplifier (360) is configured to detect a first capacitance at the first movable electrode (122A, 122B) at the first input of the charge-to-voltage amplifier (360) and a second capacitance at the second movable electrode (132A, 132B) at the second input of the charge-to-voltage amplifier (360) during the second state.

2. The accelerometer device (300) of claim 1, wherein the charge-to-voltage amplifier (360) is electrically coupled to a level-shifting circuit (370).

3. The accelerometer device (300) of claim 2, wherein the level-shifting circuit (370) is configured to shift the first input potential at the first input and the second input potential at the second input to a ground potential at the first movable electrode (122A, 122B) and at the second movable electrode (132A, 132B).

4. The accelerometer device (300) of claim 2, wherein the level-shifting circuit (370) includes a first capacitor (371) that electrically couples the first input of the charge-to-voltage amplifier (360) to the first movable electrode (122A, 122B).

5. The accelerometer device (300) of claim 2, wherein the level-shifting circuit (370) includes a switched capacitor circuit (373, 376), wherein the switch capacitor circuit (373, 376) is configured to apply the fixed ground potential (344) to the first movable electrode (122A, 122B) and to the second movable electrode (132A, 132B) in the first state and is further configured to electrically couple the first movable electrode (122A, 122B) to the first input of the charge-to-voltage amplifier (360) and the second movable electrode (132A, 132B) to the second input of the charge-to-voltage amplifier (360) in the second state.

6. A method comprising:
coupling a shield structure (140) to a substrate (110), to a first proof mass (120), and to a second proof mass (130), wherein the first proof mass (120) includes a first movable electrode (122A, 122B) that is electrically coupled to a first fixed electrode (124) and a second fixed electrode (125), and wherein the second proof mass (130) includes a second movable electrode (132A, 132B) that is electrically coupled to a third fixed electrode (134) and to a fourth fixed electrode (135);
coupling the shield structure (140) to the substrate (110), the first proof mass (120), and the second proof mass (130);
electrically coupling the shield structure (140) to a fixed ground potential (344);
electrically coupling driver circuitry (320) to the first fixed electrode (124), second fixed electrode (125), third fixed electrode (134), and fourth fixed electrode (135);
electrically coupling a voltage source to the driver circuitry (320), the voltage source having a reference voltage at an input to the voltage source, wherein the voltage source is configured to amplify the reference voltage to a maximum regulated voltage;
maintaining, by the driver circuitry (320), a ground potential at the first fixed electrode (124), the second fixed electrode the third fixed electrode (134), and the fourth fixed electrode (135) in a first state and is configured to apply a first excitation voltage at the first fixed electrode (124) and the third fixed electrode (134) at the maximum regulated voltage and a second excitation voltage at the second fixed electrode (125) and fourth fixed electrode (135) having a value opposite to in polarity of the first excitation voltage during a second state;
electrically coupling a charge pump (350) to the driver circuitry (320), wherein the charge pump (350) is configured to produce a voltage opposite to in polarity to the maximum regulated voltage, wherein a difference in a magnitude of the voltage and the magnitude of the maximum regulated voltage is less than twenty percent of the magnitude of the voltage; and
electrically coupling a charge-to-voltage amplifier (360) having a first input and a second input to the first movable electrode (122A, 122B) and to the second movable electrode (132A, 132B), wherein the charge-to-voltage amplifier (360) is configured to detect a first capacitance at the first movable electrode (122A, 122B) at the first input of the charge-to-voltage amplifier (360) and a second capacitance at the second movable electrode (132A, 132B) at the second input of the charge-to-voltage amplifier (360) during the second state.

7. The method of claim 6, wherein a level shifting circuit (370) is used to shift the voltage of the first movable electrode (122A, 122B) and the second movable electrode (132A, 132B) from ground potential to the reference voltage at the first input of the charge-to-voltage amplifier (360) during the first state.

## Patentansprüche

1. Beschleunigungsmessvorrichtung (300), umfassend:
- eine Abschirmstruktur (140), die mit einem Substrat (110), mit einer ersten Prüflast (120) und mit einer zweiten Prüflast (130) gekoppelt ist, wobei die erste Prüflast (120) eine erste bewegliche Elektrode (122A, 122B) enthält, die mit einer ersten festen Elektrode (124) und einer zweiten festen Elektrode (125) elektrisch verbunden ist, und wobei die zweite Prüflast (130) eine zweite bewegliche Elektrode (132A, 132B) enthält, die mit einer dritten festen Elektrode (134) und mit einer vierten festen Elektrode (135) elektrisch verbunden ist, wobei die Abschirmstruktur (140) weiter elektrisch mit einem festen Erdpotential (344) verbunden ist;
- eine Spannungsquelle, die elektrisch mit einer Treiberschaltung (320) verbunden ist, wobei die Spannungsquelle eine Referenzspannung an einem Eingang der Spannungsquelle aufweist, wobei die Spannungsquelle dazu konfiguriert ist, die Referenzspannung auf eine maximal geregelte Spannung zu verstärken;
- wobei die Treiberschaltung (320) weiter mit der ersten festen Elektrode (124), zweiten festen Elektrode (125), dritten festen Elektrode (134) und vierten festen Elektrode (135) elektrisch verbunden ist, wobei die Treiberschaltung (320) dazu konfiguriert ist, in einem ersten Zustand ein Erdpotenzial an der ersten festen Elektrode (124), der zweiten festen Elektrode, der dritten festen Elektrode (134) und der vierten festen Elektrode (135) aufrechtzuerhalten, und dazu konfiguriert ist, in einem zweiten Zustand eine erste Erregerspannung an die erste feste Elektrode (124) und die dritte feste Elektrode (134) mit der maximal geregelten Spannung und eine zweite Erregerspannung an die zweite feste Elektrode (125) und die vierte feste Elektrode (135) anzulegen, die hinsichtlich der Polarität einen der ersten Erregerspannung entgegengesetzten Wert aufweist;
- eine Ladungspumpe (350), die mit der Treiberschaltung (320) elektrisch verbunden ist, wobei die Ladungspumpe (350) dazu konfiguriert ist, eine Spannung zu erzeugen, die hinsichtlich der Polarität der maximal geregelten Spannung entgegengesetzt ist, wobei eine Differenz in einer Größenordnung der Spannung und der Größenordnung der maximal geregelten Spannung weniger als zwanzig Prozent der Größenordnung der Spannung beträgt; und
- ein Ladungsverstärker (360) mit einem ersten Eingang und einem zweiten Eingang, elektrisch gekoppelt an die erste bewegliche Elektrode (122A, 122B) und an die zweite bewegliche Elektrode (132A, 132B), wobei der Ladungsverstärker (360) dazu konfiguriert ist, während des zweiten Zustands eine erste Kapazität an der ersten beweglichen Elektrode (122A, 122B) an dem ersten Eingang des Ladungsverstärkers (360) und eine zweite Kapazität an der zweiten beweglichen Elektrode (132A, 132B) an dem zweiten Eingang des Ladungsverstärkers (360) zu erkennen.

2. Beschleunigungsmessvorrichtung (300) nach Anspruch 1, wobei der Ladungsverstärker (360) mit einem Pegelumsetzer (370) elektrisch verbunden ist.

3. Beschleunigungsmessvorrichtung (300) nach Anspruch 2, wobei der Pegelumsetzer (370) dazu konfiguriert ist, das erste Eingangspotential an dem ersten Eingang und das zweite Eingangspotential an dem zweiten Eingang auf ein Erdpotential an der ersten beweglichen Elektrode (122A, 122B) und an der zweiten beweglichen Elektrode (132A, 132B) zu verschieben.

4. Beschleunigungsmessvorrichtung (300) nach Anspruch 2, wobei der Pegelumsetzer (370) einen ersten Kondensator (371) enthält, der den ersten Eingang des Ladungsverstärkers (360) mit der ersten beweglichen Elektrode (122A, 122B) elektrisch koppelt.

5. Beschleunigungsmessvorrichtung (300) nach Anspruch 2, wobei der Pegelumsetzer (370) eine Schaltung mit geschalteten Kondensatoren (373, 376) enthält, wobei die Schaltung mit geschalteten Kondensatoren (373, 376) dazu konfiguriert ist, in dem ersten Zustand das feste Erdpotenzial (344) an die erste bewegliche Elektrode (122A, 122B) und an die zweite bewegliche Elektrode (132A, 132B) anzulegen und weiter dazu konfiguriert ist, in dem zweiten Zustand die erste bewegliche Elektrode (122A, 122B) mit dem ersten Eingang des Ladungsverstärkers (360) und die zweite bewegliche Elektrode (132A, 132B) mit dem zweiten Eingang des Ladungsverstärkers (360) elektrisch zu koppeln.

6. Verfahren, das Folgendes umfasst:
Koppeln einer Abschirmstruktur (140) an ein Substrat (110), an eine erste Prüfmasse (120) und an eine zweite Prüfmasse (130), wobei die erste Prüfmasse (120) eine erste bewegliche Elektrode (122A, 122B) enthält, die mit einer ersten festen Elektrode (124) und einer zweiten festen Elektrode (125) elektrisch gekoppelt ist, und wobei die zweite Prüfmasse (130) eine zweite bewegliche Elektrode (132A, 132B) enthält, die mit einer dritten festen Elektrode (134) und einer vierten festen Elektrode (135) elektrisch gekoppelt ist;
Koppeln der Abschirmstruktur (140) mit dem Substrat (110), der ersten Prüfmasse (120) und der zweiten Prüfmasse (130);
elektrisches Koppeln der Abschirmstruktur (140) mit einem festen Erdpotenzial (344);
elektrisches Koppeln der Treiberschaltung (320) mit der ersten festen Elektrode (124), zweiten festen Elektrode (125), dritten festen Elektrode (134) und vierten festen Elektrode (135);
elektrisches Koppeln einer Spannungsquelle mit der Treiberschaltung (320), wobei die Spannungsquelle eine Referenzspannung an einem Eingang der Spannungsquelle aufweist, wobei die Spannungsquelle dazu konfiguriert ist, die Referenzspannung auf eine maximal geregelte Spannung zu verstärken;
Aufrechterhalten eines Erdpotenzials an der ersten festen Elektrode (124), der zweiten festen Elektrode, der dritten festen Elektrode (134) und der vierten festen Elektrode (135) in dem ersten Zustand durch die Treiberschaltung (320), und ist dazu konfiguriert, eine erste Erregerspannung an die erste feste Elektrode (124) und die dritte feste Elektrode (134) bei der maximal geregelten Spannung und eine zweite Erregerspannung an die zweite feste Elektrode (125) und die vierte feste Elektrode (135) anzulegen, die während eines zweiten Zustands einen hinsichtlich Polarität der ersten Erregerspannung entgegengesetzten Wert aufweist;
elektrisches Koppeln einer Ladungspumpe (350) mit der Treiberschaltung (320), wobei die Ladungspumpe (350) dazu konfiguriert ist, eine Spannung zu erzeugen, die hinsichtlich der Polarität der maximal geregelten Spannung entgegengesetzt ist, wobei die Differenz in der Größenordnung der Spannung und der Größenordnung der maximal geregelten Spannung weniger als zwanzig Prozent der Größenordnung der Spannung beträgt; und
elektrisches Koppeln eines Ladungsverstärkers (360) mit einem ersten Eingang und einem zweiten Eingang mit der ersten beweglichen Elektrode (122A, 122B) und mit der zweiten beweglichen Elektrode (132A, 132B), wobei der Ladungsverstärker (360) dazu konfiguriert ist, während des zweiten Zustands eine erste Kapazität an der ersten beweglichen Elektrode (122A, 122B) an dem ersten Eingang des Ladungsverstärkers (360) und eine zweite Kapazität an der zweiten beweglichen Elektrode (132A, 132B) an dem zweiten Eingang des Ladungsverstärkers (360) zu erkennen.

7. Verfahren nach Anspruch 6, wobei ein Pegelumsetzer (370) verwendet wird, um die Spannung der ersten beweglichen Elektrode (122A, 122B) und der zweiten beweglichen Elektrode (132A, 132B) während des ersten Zustands von dem Erdpotenzial auf die Referenzspannung an dem ersten Eingang des Ladungsverstärkers (360) zu verschieben.

## Revendications

1. Dispositif d'accéléromètre (300) comprenant :
- une structure de blindage (140) accouplée à un substrat (110), à une première masse étalon (120) et à une deuxième masse étalon (130), dans laquelle la première masse étalon (120) comporte une première électrode mobile (122A, 122B) qui est couplée électriquement à une première électrode fixe (124) et à une deuxième électrode fixe (125), et dans laquelle la deuxième masse étalon (130) comporte une deuxième électrode mobile (132A, 132B) qui est couplée électriquement à une troisième électrode fixe (134) et à une quatrième électrode fixe (135), la structure de blindage (140) étant en outre couplée électriquement à un potentiel de masse fixe (344) ;
- une source de tension couplée électriquement à un montage de pilotage (320), la source de tension ayant une tension de référence à une entrée de la source de tension, la source de tension étant configurée pour amplifier la tension de référence jusqu'à une tension régulée maximale ;
- le montage de pilotage (320) étant en outre couplé électriquement à la première électrode fixe (124), la deuxième électrode fixe (125), la troisième électrode fixe (134) et la quatrième électrode fixe (135), dans lequel le montage de pilotage (320) est configuré pour maintenir un potentiel de masse au niveau de la première électrode fixe (124), la deuxième électrode fixe, la troisième électrode fixe (134) et la quatrième électrode fixe (135) dans un premier état et est configuré pour appliquer une première tension d'excitation à la première électrode fixe (124) et la troisième électrode fixe (134) à la tension régulée maximale et une deuxième tension d'excitation à la deuxième électrode fixe (125) et la quatrième électrode fixe (135) ayant une valeur opposée en polarité de la première tension d'excitation pendant un deuxième état ;
- une pompe de charge (350) couplée électriquement au montage de pilotage (320), la pompe de charge (350) étant configurée pour produire une tension opposée en polarité à la tension régulée maximale, dans laquelle une différence entre l'amplitude de la tension et l'amplitude de la tension régulée maximale est inférieure à vingt pour cent de l'amplitude de la tension ; et
- un amplificateur charge-tension (360), ayant une première entrée et une deuxième entrée, couplé électriquement à la première électrode mobile (122A, 122B) et à la deuxième électrode mobile (132A, 132B), dans lequel l'amplificateur charge-tension (360) est configuré pour détecter une première capacité au niveau de la première électrode mobile (122A, 122B) sur la première entrée de l'amplificateur charge-tension (360) et une deuxième capacité au niveau de la deuxième électrode mobile (132A, 132B) sur la deuxième entrée de l'amplificateur charge-tension (360) pendant le deuxième état.

2. Dispositif d'accéléromètre (300) selon la revendication 1, dans lequel l'amplificateur charge-tension (360) est couplé électriquement à un circuit adaptateur de niveau (370).

3. Dispositif d'accéléromètre (300) selon la revendication 2, dans lequel le circuit adaptateur de niveau (370) est configuré pour faire passer le premier potentiel d'entrée sur la première entrée et le deuxième potentiel d'entrée sur la deuxième entrée à un potentiel de masse sur la première électrode mobile (122A, 122B) et sur la deuxième électrode mobile (132A, 132B).

4. Dispositif d'accéléromètre (300) selon la revendication 2, dans lequel le circuit adaptateur de niveau (370) comprend un premier condensateur (371) qui relie électriquement la première entrée de l'amplificateur charge-tension (360) à la première électrode mobile (122A, 122B).

5. Dispositif d'accéléromètre (300) selon la revendication 2, dans lequel le circuit adaptateur de niveau (370) comprend un circuit de condensateur commuté (373, 376), le circuit de condensateur commuté (373, 376) étant configuré pour appliquer le potentiel de masse fixe (344) à la première électrode mobile (122A, 122B) et à la deuxième électrode mobile (132A, 132B) dans le premier état et étant configuré en outre pour coupler électriquement la première électrode mobile (122A, 122B) à la première entrée de l'amplificateur charge-tension (360) et la deuxième électrode mobile (132A, 132B) à la deuxième entrée de l'amplificateur charge-tension (360) dans le deuxième état.

6. Procédé comprenant les étapes suivantes :
accoupler une structure de blindage (140) à un substrat (110), à une première masse étalon (120) et à une deuxième masse étalon (130), dans laquelle la première masse étalon (120) comporte une première électrode mobile (122A, 122B) qui est couplée électriquement à une première électrode fixe (124) et à une deuxième électrode fixe (125), et dans laquelle la deuxième masse étalon (130) comporte une deuxième électrode mobile (132A, 132B) qui est couplée électriquement à une troisième électrode fixe (134) et à une quatrième électrode fixe (135) ;
accoupler la structure de blindage (140) au substrat (110), à la première masse étalon (120) et à la deuxième masse étalon (130) ;
coupler électriquement la structure de blindage (140) à un potentiel de masse fixe (344) ;
coupler électriquement un montage de pilotage (320) à la première électrode fixe (124), la deuxième électrode fixe (125), la troisième électrode fixe (134) et la quatrième électrode fixe (135) ;
coupler électriquement une source de tension au montage de pilotage (320), la source de tension ayant une tension de référence à une entrée de la source de tension, la source de tension étant configurée pour amplifier la tension de référence jusqu'à une tension régulée maximale ;
maintenir, au moyen du montage de pilotage (320), un potentiel de masse au niveau de la première électrode fixe (124), la deuxième électrode fixe, la troisième électrode fixe (134) et la quatrième électrode fixe (135) dans un premier état et appliquer une première tension d'excitation à la première électrode fixe (124) et la troisième électrode fixe (134) à la tension régulée maximale et une deuxième tension d'excitation à la deuxième électrode fixe (125) et la quatrième électrode fixe (135) ayant une valeur opposée en polarité de la première tension d'excitation pendant un deuxième état ;
coupler électriquement une pompe de charge (350) au montage de pilotage (320), la pompe de charge (350) étant configurée pour produire une tension opposée en polarité à la tension régulée maximale, dans laquelle une différence entre l'amplitude de la tension et l'amplitude de la tension régulée maximale est inférieure à vingt pour cent de l'amplitude de la tension ; et
coupler électriquement un amplificateur charge-tension (360) ayant une première entrée et une deuxième entrée à la première électrode mobile (122A, 122B) et à la deuxième électrode mobile (132A, 132B), dans lequel l'amplificateur charge-tension (360) est configuré pour détecter une première capacité au niveau de la première électrode mobile (122A, 122B) sur la première entrée de l'amplificateur charge-tension (360) et une deuxième capacité au niveau de la deuxième électrode mobile (132A, 132B) sur la deuxième entrée de l'amplificateur charge-tension (360) pendant le deuxième état.

7. Procédé selon la revendication 6, dans lequel on utilise un circuit adaptateur de niveau (370) pour faire passer la tension de la première électrode mobile (122A, 122B) et de la deuxième électrode mobile (132A, 132B) du potentiel de masse à la tension de référence sur la première entrée de l'amplificateur charge-tension (360) pendant le premier état.
